# FASCICULE DE BREVET EUROPEEN

(11) **EP 2 761 981 B1**
(45) Date de publication et mention de la délivrance du brevet: **13.12.2017**
(21) Numéro de dépôt: 12783639.3
(22) Date de dépôt: 25.09.2012
(51) Int. Cl.: H05K 7/14, B60R 16/02, B60R 16/03

(54) **MEUBLE ELECTRIQUE D'UN AERONEF INCORPORANT UN SYSTEME DE RACCORDEMENT ELECTRIQUE AMELIORE**
SCHALTSCHRANK FÜR EIN FLUGZEUG MIT VERBESSERTEM STROMANSCHLUSSSYSTEM
ELECTRICAL CABINET FOR AN AIRCRAFT, INCLUDING AN IMPROVED ELECTRICAL CONNECTION SYSTEM

(30) Priorité: 30.09.2011 FR 1158827
(43) Date de publication de la demande: 06.08.2014
(73) Titulaire: Airbus Operations S.A.S., 31060 Toulouse (FR)
(72) Inventeur: GUERING, Bernard, F-31850 Montrabe (FR); DURAND, Yves, F-31840 Aussonne (FR)
(74) Mandataire: Fantin, Laurent
(86) Numéro de dépôt international: PCT/FR2012/052139
(87) Numéro de publication internationale: WO 2013/045810

(56) Documents cités:
- EP-A1- 1 793 659
- EP-A1- 2 330 879
- FR-A1- 2 783 392
- FR-A1- 2 927 222
- US-A- 5 376 011

## Description

La présente invention se rapporte à un meuble électrique d'un aéronef incorporant un système de raccordement électrique amélioré. Le document FR 2 783 392 décrit un meuble électrique d'un aéronef selon le préambule de la revendication 1.

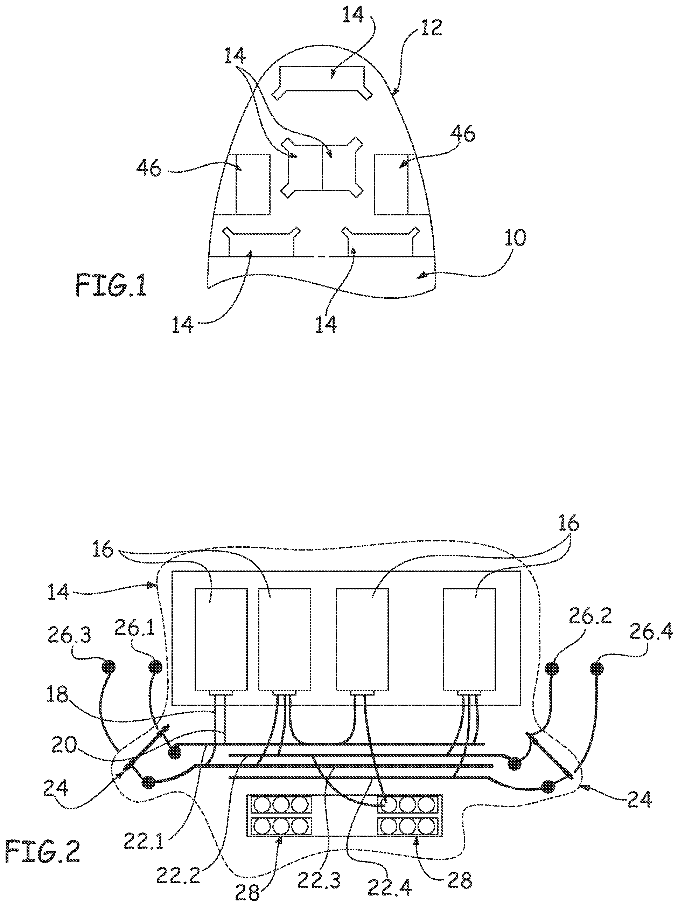

Comme illustré sur la figure 1, un avion civil comprend une cabine 10 avec à l'avant une pointe avant 12 contenant notamment un cockpit et une soute avionique. Cette pointe avant 12 comprend de nombreux meubles électriques 14 qui ont tendance à occuper de plus en plus de place compte tenu des besoins croissants en fonctions électriques. Ces meubles électriques 14 sont situés généralement dans la soute avionique. Toutefois, certains peuvent être également intégrés dans le cockpit. Dans ce cas, les meubles électriques doivent cohabiter avec les autres éléments du cockpit. Aussi, il est nécessaire que ces meubles soient relativement compacts et puissent être reliés au reste du circuit électrique de l'aéronef dans de bonnes conditions pour les opérateurs qui doivent cohabiter dans cet espace restreint avec d'autres opérateurs chargés du montage d'autres éléments dans le cockpit.

Concernant le réseau électrique de l'aéronef, ce dernier est organisé en harnais électriques regroupant plusieurs câbles électriques en raison de problématique de production et de ségrégation liée à la sécurité. Ces harnais électriques cheminent dans la pointe avant afin que les câbles électriques soient reliés aux meubles électriques.

Selon un mode de réalisation connu conforme à la norme Arinc 600, illustré sur la figure 2, un meuble électrique 14 comprend plusieurs modules 16 répartis sur plusieurs étagères (une seule est représentée sur la figure 2).

Chaque module 16, associé à une ou plusieurs fonctions électriques, comprend au moins un câble d'entrée 18 et au moins un câble de sortie 20 et au moins un composant permettant de traiter le signal électrique entre le câble d'entrée 18 et le câble de sortie 20. Par traiter le signal électrique, on entend toutes actions sur ledit signal à savoir aussi bien une modification qu'un simple contrôle ou lecture.

Les câbles d'entrée 18 et les câbles de sortie 20 sont organisés et regroupés en routes 22.1 à 22.4 à l'intérieur de l'armoire de manière à être en phase avec les harnais électriques de l'aéronef.

Le meuble électrique 16 comprend au niveau de chacun de ses côtés verticaux des platines de coupure 24 au niveau desquelles sont prévus des moyens de connexion entre les routes 22.1 à 22.4 du meuble électrique et les harnais 26.1 à 26.4 du circuit électrique de l'aéronef.

Dans la partie arrière du meuble, il existe également des câbles assurant la liaison électrique entre deux modules d'une même étagère ou d'étagères différentes. Dans ce dernier cas, les câbles électriques peuvent être regroupés sous forme d'harnais électriques 28 qui s'étendent sur au moins une partie de la hauteur du meuble au niveau de sa partie arrière.

Cette conception conduit à des meubles imposants avec une densité de composants relativement faible.

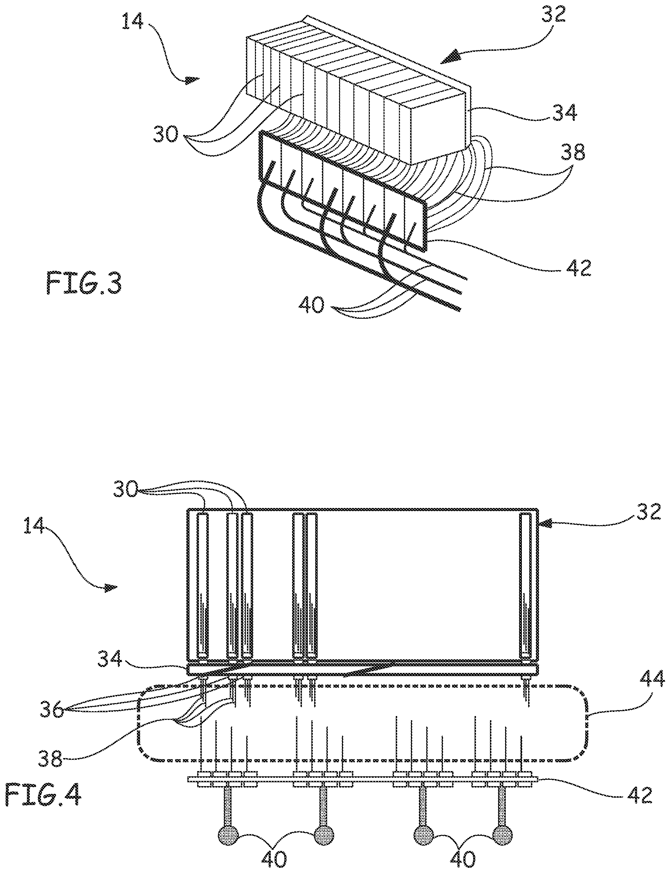

Dans le domaine de l'avionique, il existe un autre standard dit IMA (Integrated Modular Avionics) qui propose de placer les modules au plus près des besoins, ce qui conduit à une architecture non centralisée comme dans le cas de la norme Arinc 600 mais éclatée dans tout l'aéronef. Selon ce nouveau standard illustré sur les figures 3 et 4, les fonctions électriques se présentent sous forme de cartes 30 également appelées cartes PCB regroupées dans un coffre 32 comportant un châssis avec une carte mère 34 à l'arrière sur laquelle sont enfichées les cartes PCB 30. Cette carte mère 34 comprend des ports 36 permettant de relier des câbles 38 d'entrée ou de sortie.

Ces câbles 38 sont ensuite organisés et regroupés en routes de manière à être en phase avec les harnais électriques de l'aéronef. Les routes de câbles 38 sont connectées aux harnais électriques 40 de l'aéronef au niveau de platines de coupure 42.

Ce type d'architecture permet d'obtenir un ensemble plus compact dans la mesure où les cartes PCB 30 permettent de relier sans câble les composants nécessaires pour assurer les fonctions.

Selon un autre avantage, la carte mère 34 peut comprendre des circuits permettant d'assurer la liaison entre les cartes PCB 30 d'un même coffre 32 ce qui tend à supprimer certains câbles par rapport à l'architecture de type Arinc 600.

Toutefois, lorsque deux cartes PCB 30 supportées par des cartes mères différentes doivent être reliées électriquement, il est nécessaire de prévoir un câble électrique qui transite via les harnais électriques du circuit de l'aéronef. Selon un autre inconvénient, si ces éléments sont agencés sous forme d'un meuble et que chaque carte mère 34 correspond à une étagère alors un tel meuble comprend comme précédemment une zone 44 où les câbles 38 sont organisés et regroupés en routes de manière à être en phase avec les harnais électriques de l'aéronef ce qui tend à augmenter le volume du meuble et ne permet d'optimiser la densité des composants.

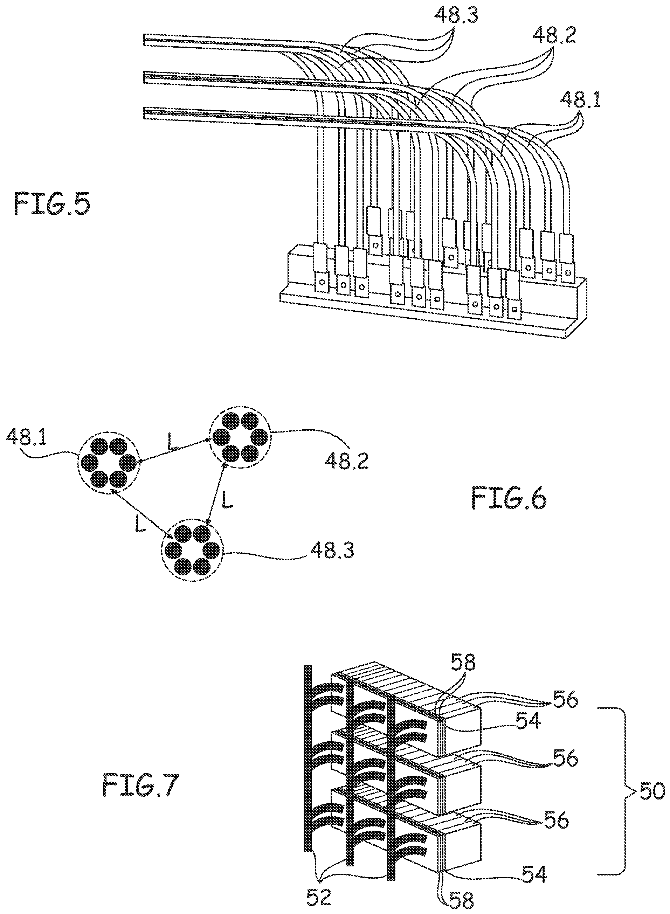

Dans le même sens, pour certains meubles électriques appelés coeurs électriques 46 (visibles sur la figure 1), il est nécessaire de prévoir un espace suffisant à l'arrière pour pouvoir relier par l'intermédiaire de cosses des câbles de génération 48.1 à 48.3, comme illustré sur la figure 5. Ces câbles qui s'étendent depuis les motorisations jusqu'au coeur électrique ont des sections importantes compte tenu des puissances électriques transférées, ces sections étant d'autant plus importantes qu'ils sont réalisés en alliage d'aluminium pour un gain de masse. En raison de leurs sections importantes et de leurs raideurs, ces câbles ont besoin d'un rayon de courbure important et peuvent difficilement cheminer dans un volume restreint.

Comme illustré sur la figure 6, les câbles de génération 48.1 à 48.3 comprennent pour chaque phase au moins deux conducteurs, ce qui tend à accroitre leurs raideurs.

Compte tenu des raideurs des câbles et du manque de précision de leurs positionnements, la distance de ségrégation L (appelée également garde) entre les câbles est importante ce qui va à l'encontre d'un cheminement dans un volume restreint.

Selon une autre problématique, le sol à l'arrière du coeur électrique 46 n'est pas plat et suit le profil du fuselage ce qui rend encore plus difficile la connexion des câbles de génération.

Aussi, la présente invention vise à pallier les inconvénients de l'art antérieur en proposant une nouvelle architecture de meuble électrique qui intègre un système de raccordement au reste du circuit de l'aéronef amélioré.

A cet effet, l'invention a pour objet un meuble électrique d'un aéronef comprenant au moins une carte mère comportant sur une première face des prises au niveau desquelles sont enfichées des cartes PCB assurant une ou plusieurs fonctions électriques, ledit meuble électrique étant relié au circuit électrique de l'aéronef organisé en différents harnais électriques par l'intermédiaire d'un système de raccordement électrique, le système de raccordement électrique comprenant au niveau de la seconde face de la carte mère au moins une couche supplémentaire, la ou les couche(s) supplémentaire(s) comprenant des pistes électriques qui permettent de réorganiser les circuits électriques issus des prises destinées aux cartes PCB pour les rendre conformes aux prises destinées aux harnais électriques de l'aéronef, caractérisé en ce que la face libre de la dernière couche supplémentaire comprend lesdites prises assurant chacune la connexion électrique avec un harnais électrique de l'aéronef. D'autres caractéristiques et avantages ressortiront de la description qui va suivre de l'invention, description donnée à titre d'exemple uniquement, en regard des dessins annexés sur lesquels :
- la figure 1 est une vue de dessus schématique illustrant de manière schématique des meubles électriques selon l'art antérieur au niveau d'une pointe avant d'un aéronef,
- la figure 2 est une représentation schématique d'un meuble électrique selon une première variante de l'art antérieur,
- la figure 3 est une vue schématique en perspective d'un meuble électrique selon une deuxième variante de l'art antérieur,
- la figure 4 est une représentation schématique d'un meuble électrique selon la deuxième variante de l'art antérieur,
- la figure 5 est une vue d'une partie de l'arrière d'un coeur électrique selon l'art antérieur illustrant la connexion de câbles de génération,
- la figure 6 est une coupe illustrant les câbles de génération et leur espacement,
- la figure 7 est une vue schématique en perspective d'un meuble électrique selon l'invention,
- la figure 8 est une représentation schématique du meuble électrique selon l'invention,
- la figure 9 est une vue en perspective illustrant une extension d'un coeur électrique selon l'invention,
- la figure 10 est une vue en perspective illustrant de manière schématique une extension d'un coeur électrique selon l'invention,
- la figure 11 est une coupe transversale d'une extension d'un coeur électrique,
- la figure 12 est une coupe transversale illustrant des détails d'une extension d'un coeur électrique, et
- la figure 13 est une représentation schématique d'un exemple d'intégration de meubles électriques dans un cockpit d'un aéronef grâce aux agencements des meubles selon l'invention.

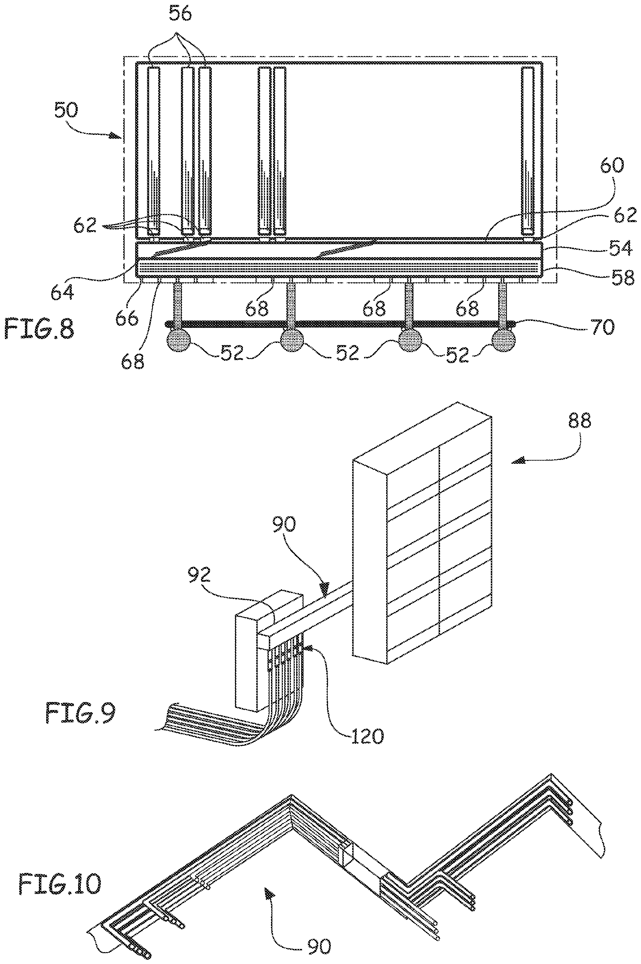

Sur les figures 7 et 8, on a représenté en 50 un meuble électrique selon l'invention qui doit être relié au circuit électrique de l'aéronef organisé en différents harnais électriques 52.

Pour la présente demande, on entend par un meuble électrique aussi bien un meuble comportant des éléments électriques, qu'un meuble comportant des éléments électroniques qu'un meuble comportant des éléments électriques et électroniques.

Un meuble électrique 50 comprend un support sur lequel peut être rapportées plusieurs cartes mères 54 (trois sur l'exemple) disposées verticalement les unes au-dessus des autres, chacune correspondant à une étagère. Des cartes PCB 56 sont enfichées sur les cartes mères 54.

Selon une variante simplifiée, un meuble électrique peut comprendre une seule carte mère 54.

Chaque carte PCB 56 correspond à une ou plusieurs fonctions électriques. Les cartes PCB 56 et les cartes mères 54 ne sont pas plus décrites car elles sont connues de l'homme du métier, et correspondent au standard IMA. Contrairement à ce standard, les cartes mères 54 ne sont pas réparties dans l'aéronef mais regroupées dans un meuble électrique.

Selon une caractéristique importante, chaque carte mère 54 comprend au moins une couche supplémentaire 58 comportant des pistes électriques permettant de réorganiser les sorties électriques de la carte mère 54 et de sa ou ses couches supplémentaires de manière à être en phase avec les harnais électriques de l'aéronef.

Comme illustré sur les figures 7 et 8, chaque carte mère 54 comprend au niveau d'une première face 60 des prises 62 permettant d'enficher les cartes PCB 56. Sur cette première face 60 ou sur sa seconde face 64, chaque carte mère 54 comprend des pistes électriques assurant des connexions entre les cartes PCB 56 d'une même carte mère 54.

Chaque carte mère 54 comprend au niveau de sa seconde face 64 au moins une couche supplémentaire 58, la face libre 66 de la dernière couche supplémentaire comprenant des prises 68 assurant chacune la connexion électrique avec un harnais électrique de l'aéronef.

Cette ou ces couches supplémentaires 58 comprennent des pistes qui permettent de réorganiser les circuits électriques issus des prises 62 destinées aux cartes PCB 56 pour les rendre conformes aux prises 68 destinées aux harnais de l'aéronef vis-à-vis des problèmes de ségrégation et de sécurité des routes électriques composant les harnais.

La superposition de couches supplémentaires permet de croiser les pistes sans contact électrique entre les pistes des différentes couches. Ainsi, le nombre de couches supplémentaires n'étant pas limité, il est possible d'augmenter les ségrégations et les redondances dans un volume très restreint.

Selon un autre avantage, il est possible de supprimer les platines de coupures des meubles électriques selon la norme Arinc 600.

La suppression des câbles à l'intérieur du meuble électrique permet à volume égal d'intégrer beaucoup plus de composants et donc de fonctions électriques.

Les harnais de l'aéronef peuvent être réorganisés en fonction de cette nouvelle architecture des meubles électriques.

En complément des meubles électriques, des rampes 70 sont prévues à l'arrière des meubles pour maintenir les harnais électriques verticalement mais également des câbles assurant l'interconnexion entre deux cartes mères 54 d'un même meuble. Selon un mode de réalisation chaque rampe se présente sous la forme d'une tige rigide avec un diamètre par exemple de l'ordre de 8 mm qui est reliée aux différents harnais et qui comprend des pattes de fixation pour la fixer à l'aéronef ou à tout autre élément présent dans l'aéronef. De préférence, les rampes sont reliées aux harnais après la réalisation de ces derniers en dehors de l'aéronef et permettent ainsi de maintenir les harnais dans leurs positions respectives lors de la mise en place des harnais dans l'aéronef.

Selon une autre caractéristique, les câbles de génération provenant notamment des génératrices des réacteurs ne sont pas reliés directement à la face arrière d'un coeur électrique 88 mais au niveau d'au moins une extension 90 qui s'étend depuis l'arrière du coeur électrique jusqu'à une platine de connexion 92 décalée par rapport à au moins un des côtés dudit coeur électrique, comme illustré sur les figures 9 et 10. Ainsi, il n'est pas nécessaire de prévoir un espace important entre la face arrière du coeur électrique et la paroi du fuselage pour assurer la connexion des câbles de génération.

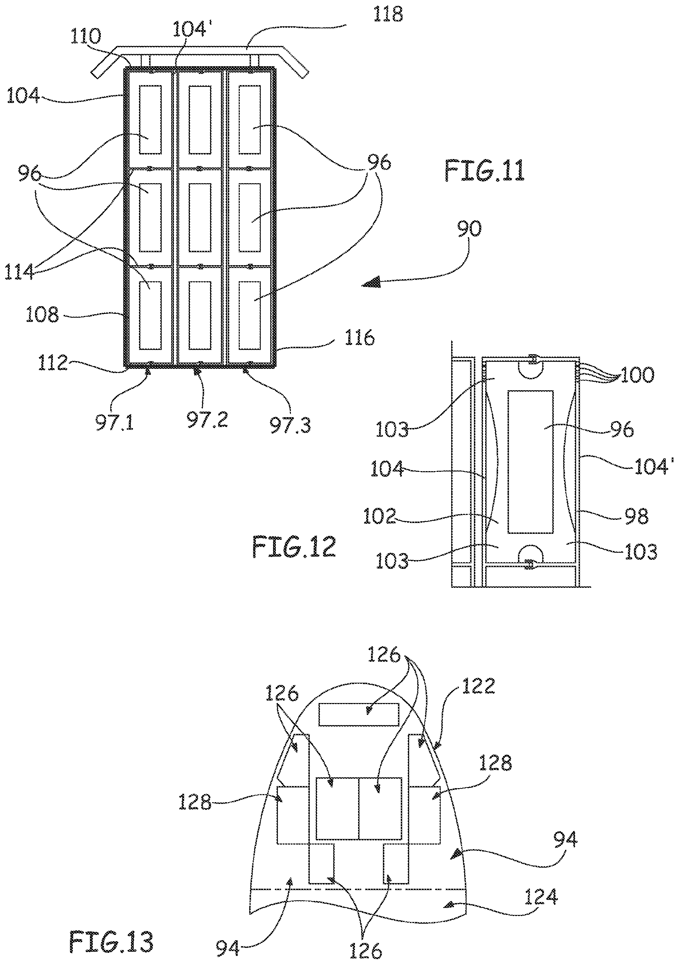

Avantageusement, la platine de connexion 92 est disposée dans une zone 94 correspondant à un centre de connexion latéral visible sur la figure 13.

Cette zone 94 est plus accessible que la zone située à l'arrière du coeur électrique et offre un sol plat qui améliore les conditions de travail des opérateurs chargés de l'industrialisation ou de la maintenance. L'extension comprend pour chaque phase de chaque ligne de génération un élément conducteur électrique 96 en cuivre.

Pour la suite de la description, on entend par cuivre aussi bien du cuivre qu'un alliage de cuivre.

L'extension 90 constitue une partie intégrante du coeur électrique 88. Par conséquent, le gain en volume étant prioritaire sur le gain de masse, il est possible de ne prévoir qu'un seul élément conducteur avec une section importante par phase pour chaque ligne de génération contrairement aux câbles de génération en alliage d'aluminium qui comprennent au moins deux éléments conducteurs avec une section inférieure par phase pour limiter l'échauffement des éléments conducteurs.

A titre d'exemple sur la figure 11, on a représenté neuf conducteurs électriques, trois phases pour trois lignes de génération 97.1, 97.2 et 97.3.

Le fait d'utiliser comme matériau du cuivre au lieu d'un alliage d'aluminium confère aux éléments conducteurs 96 une aptitude au pliage plus importante avec des rayons de pliage de l'ordre de 1 à 2 mm possible.

Selon un autre avantage, le cuivre a une dilatation thermique plus faible que les alliages d'aluminium utilisés pour réaliser les câbles de génération selon l'art antérieur.

Selon une autre caractéristique, les éléments conducteurs 96 sont rigides et se présentent chacun sous la forme d'une barre rigide en cuivre.

Le fait de prévoir des éléments rigides permet de réduire la garde entre chaque élément conducteur.

Selon une autre caractéristique, chaque élément conducteur 96 est disposé dans un conduit rigide 98 en un matériau isolant électriquement, le conduit rigide 98 ayant une section suffisante pour que l'élément conducteur soit séparé de la face intérieure du conduit par une lame d'air concentrique à l'élément conducteur 96.

Cette lame d'air favorise également le refroidissement des éléments conducteurs 96. Selon un premier point, dans la mesure où chaque conduit rigide 98 communique avec l'intérieur du coeur électrique et que l'intérieur de ce dernier est ventilé par une ventilation forcé, un flux d'air forcé est produit à l'intérieur de chaque conduit 98. Selon un autre point, des orifices 100 (visibles sur la figure 12) sont pratiqués régulièrement sur chaque conduit 98 pour améliorer encore la ventilation des éléments conducteurs 96.

Avantageusement, des plots 102 sont prévus à l'intérieur du conduit 98, répartis à intervalles réguliers, pour maintenir l'écartement tout autour de l'élément conducteur 96.

Selon un mode de réalisation, ces plots 102 sont en silicone. Chaque plot comprend un orifice central dont la section est ajustée à celle de l'élément conducteur 96 et au niveau de sa périphérie des excroissances 103 dont les formes extérieures sont ajustées à la section du conduit 98. Entre les excroissances 103, l'air peut circuler le long du conduit 98.

Ces plots 102 assurent également un filtrage vibratoire.

Selon un mode de réalisation, les éléments conducteurs ont une section rectangulaire et comprennent une protection de surface isolante. Les conduits rigides 98 ont également une section rectangulaire.

Avantageusement, un conduit rigide 98 est constitué de deux demi-coquilles 104, 104' assemblées.

Selon un mode de réalisation, les demi-coquilles sont approximativement symétriques selon un plan médian 106, de préférence vertical. Chaque demi coquille comprend une première paroi latérale 108, une paroi supérieure 110 et une paroi inférieure 112 perpendiculaires à la paroi latérale 108 ainsi que deux cloisons 114 perpendiculaires à la paroi latérale 108 et réparties de manière régulière entre les parois supérieure 110 et inférieure 112.

Les bords libres des parois supérieure et inférieure ainsi que des cloisons des demi-coquilles ont des formes qui coopèrent pour assurer la liaison entre les deux demi-coquilles. De préférence, les deux demi-coquilles 104 et 104' sont identiques et assemblées tête-bêche. Ainsi, selon un mode de réalisation, les bords libres de la paroi supérieure et d'une des deux cloisons comprennent des fentes aptes à recevoir les bords libres de l'autre demi-coquille.

Selon l'invention, les phases d'une ligne de génération sont isolées entre elles en étant disposées dans les conduits 98 formés par deux demi-coquilles 104 et 104' assemblées. Les lignes de génération sont isolées entre elles en étant disposées dans des jeux de demi-coquilles différents. Ainsi, pour trois lignes de génération, on prévoit trois jeux de deux demi-coquilles, un espace étant ménagé entre les jeux de deux demi-coquilles.

Les trois jeux de demi-coquilles sont maintenus assemblés par une bride de maintien 116. Ainsi, l'extension 90 a une section sensiblement rectangulaire.

De préférence, un déflecteur 118 est prévu au-dessus de l'ensemble des conduits 98 pour les protéger des ruissèlements de liquide.

De préférence, l'extension 90 comprend à chaque extrémité de chaque élément conducteur un dispositif de protection différentielle comme par exemple un bobinage de type à effet Hall.

Sur le plan de la connectique, l'extrémité de chaque élément conducteur est reliée au coeur électrique par un contact de puissance, par exemple par une connexion de type « pinouille » mâle/femelle de grosse section. L'autre extrémité de chaque élément conducteur est reliée à l'élément conducteur correspondant d'un des câbles de génération, au niveau de la platine de connexion, par un raccordement de type bornier 120.

Même si le cuivre a un coefficient de dilatation faible, il est de préférence souhaitable de prévoir des moyens pour absorber les variations de longueurs des éléments conducteurs 96.

En ce sens, les moyens de raccordement entre les éléments conducteurs des câbles de génération et les éléments conducteurs des lignes de génération de l'extension sont montés flottants sur la platine de connexion 92.

En variante ou en complément, l'extension 90 comprend un profil en Z selon sa longueur avec un double pliage à 90° de manière à absorber les variations de longueurs des éléments conducteurs en raison des phénomènes de dilatation.

Les systèmes de raccordement améliorés des différentes variantes de l'invention permettent de pouvoir regrouper les meubles électriques dans un espace plus restreint. Ainsi, il est possible d'intégrer l'ensemble du matériel électrique habituellement disposé dans la soute prévue sous le cockpit dans le volume du cockpit en le faisant cohabiter avec les autres éléments normalement présents dans ledit cockpit, comme illustré sur la figure 13.

Ainsi, dans un cockpit 122 disposé à l'avant d'une cabine 124, il est possible d'intégrer des meubles électriques comme des meubles systèmes 126 ou des coeurs électriques 128.

De même, il est possible d'organiser ces différents meubles électriques de manière à dégager au niveau de la jonction entre la cabine 124 et la pointe avant contenant le cockpit 122 au moins un centre de connexion 94, de préférence un de chaque côté de l'aéronef, accessible améliorant le confort des opérateurs chargés de l'installation ou de l'entretien du réseau électrique de l'aéronef. Selon cet agencement, le réseau électrique de la cabine est relié grâce à des moyens de connexion au réseau électrique de la pointe avant de l'aéronef, ces moyens de connexion étant disposés au niveau du ou des centre(s) de connexion 94. Ainsi, il est possible d'intégrer le réseau électrique de la cabine indépendamment du réseau électrique du cockpit et de les relier par la suite au niveau d'une zone de connexion accessible.

## Revendications

1. Meuble électrique d'un aéronef comprenant au moins une carte mère (54) comportant sur une première face (60) des prises (62) au niveau desquelles sont enfichées des cartes PCB (56) assurant une ou plusieurs fonctions électriques, ledit meuble électrique (50) étant relié au circuit électrique de l'aéronef organisé en différents harnais électriques (52) par l'intermédiaire d'un système de raccordement électrique, le système de raccordement électrique comprenant au niveau de la seconde face (64) de la carte mère (54) au moins une couche supplémentaire (58), la ou les couche(s) supplémentaire(s) (58) comprenant des pistes électriques qui permettent de réorganiser les circuits électriques issus des prises (62) destinées aux cartes PCB (56) pour les rendre conformes aux prises (68) destinées aux harnais électriques (52) de l'aéronef, **caractérisé en ce que** la face libre (66) de la dernière couche supplémentaire comprend lesdites prises (68) assurant chacune la connexion électrique avec un harnais électrique (52) de l'aéronef.

2. Meuble électrique selon la revendication 1, **caractérisé en ce qu'**il comprend plusieurs cartes mères (54) disposées verticalement les unes au-dessus des autres.

3. Meuble électrique selon la revendication 2, **caractérisé en ce que** les cartes mères (54) sont prévues au niveau de la face arrière du meuble.

4. Meuble électrique selon la revendication 3, **caractérisé en ce qu'**il comprend des rampes (70) à l'arrière du meuble pour maintenir les harnais électriques de l'aéronef verticalement.

5. Aéronef comprenant un meuble électrique selon l'une des revendications précédentes.

## Patentansprüche

1. Schaltschrank eines Luftfahrzeugs mit wenigstens einer Grundplatine (54), die auf einer ersten Seite (60) Stecker (62) aufweist, in die Leiterplatten (56) eingesteckt sind, die eine oder mehrere elektrische Funktionen ermöglichen, wobei der Schaltschrank (50) mittels eines elektrischen Verkabelungssystems mit elektrischen Leitungen des Luftfahrzeugs verbunden ist, die in verschiedenen elektrischen Strängen (52) organisiert sind, wobei das elektrische Verkabelungssystem auf der zweiten Seite (64) der Grundplatine (54) wenigstens eine Ergänzungsschicht (58) aufweist, und wobei die Ergänzungsschicht(en) (58) elektrische Bahnen aufweist (aufweisen), die es gestatten, die elektrischen Leitungen, die aus den für die Leiterplatten (56) bestimmten Steckern (62) hervorgehen, umzuordnen, um diese in Übereinstimmung mit den für die elektrischen Kabelstränge (52) des Luftfahrzeugs bestimmten Stecker (68) zu bringen, **dadurch gekennzeichnet, dass** die freie Seite (66) der letzten Ergänzungsschicht die Stecker (68) umfasst, die jeweils die elektrische Verbindung mit einem elektrischen Strang (52) des Luftfahrzeugs gewährleisten.

2. Schaltschrank nach Anspruch 1, **dadurch gekennzeichnet, dass** dieser mehrere Grundplatinen (54) aufweist, die in senkrechter Richtung jeweils übereinander angeordnet sind.

3. Schaltschrank nach Anspruch 2, **dadurch gekennzeichnet, dass** die Grundplatinen (54) im Bereich der Rückseite des Schaltschranks vorgesehen sind.

4. Schaltschrank nach Anspruch 3, **dadurch gekennzeichnet, dass** dieser Stangen (70) auf der Rückseite des Schaltschranks aufweist, um die elektrischen Stränge des Luftfahrzeugs in senkrechter Richtung zu halten.

5. Luftfahrzeug mit einem elektrischen Schaltschrank nach einem der vorhergehenden Ansprüche.

## Claims

1. Electrical cabinet of an aircraft comprising at least one motherboard (54) comprising on a first face (60) sockets (62) into which are plugged PCB boards (56) ensuring one or more electrical functions, said electrical cabinet (50) being linked to the electrical circuit of the aircraft organized as various electrical harnesses (52) by way of an electrical connection system, the electrical connection system comprising at the level of the second face (64) of the motherboard (54) at least one additional layer (58), the additional layer or layers (58) comprising electrical tracks which make it possible to reorganize the electrical circuits emanating from the sockets (62) intended for the PCB boards (56) so as to render them compliant with the sockets (68) intended for the electrical harnesses (52) of the aircraft, **characterized in that** the free face (66) of the last additional layer comprises sockets (68) each ensuring electrical connection with an electrical harness of the aircraft

2. Electrical cabinet according to Claim 1, **characterized in that** it comprises several motherboards (54) disposed vertically one above another.

3. Electrical cabinet according to Claim 2, **characterized in that** the motherboards (54) are provided at the level of the rear face of the cabinet.

4. Electrical cabinet according to Claim 3, **characterized in that** it comprises rails (70) at the rear of the cabinet to hold the electrical harnesses of the aircraft vertically.

5. Aircraft comprising an electrical cabinet according to one of the preceding claims.
